# FASCICULE DE BREVET EUROPEEN

(11) **EP 4 060 355 B1**
(45) Date de publication et mention de la délivrance du brevet: **04.10.2023**
(21) Numéro de dépôt: 22162199.8
(22) Date de dépôt: 15.03.2022
(51) Int. Cl.: G01R 31/317, G01R 31/3185

(54) **PROTECTION DU CONTENU D'UNE MÉMOIRE FUSIBLE**
SCHUTZ DES INHALTS EINES SCHMELZSPEICHERS
PROTECTION OF THE CONTENTS OF A FUSE MEMORY

(30) Priorité: 18.03.2021 FR 2102717
(43) Date de publication de la demande: 21.09.2022
(73) Titulaire: STMICROELECTRONICS (GRENOBLE 2) SAS, 38000 Grenoble (FR)
(72) Inventeur: TRIMMER, Mark, 38500 COUBLEVIE (FR)
(74) Mandataire: Cabinet Beaumont

(56) Documents cités:
- CN-B- 101 620 656
- US-A1- 2005 289 355
- US-A1- 2012 278 630
- US-A1- 2019 163 909

## Description

### Domaine technique

La présente description concerne de façon générale les circuits électroniques, et plus particulièrement les circuits intégrés comportant une mémoire non volatile de type fusible. La présente description concerne, en particulier, la mise en œuvre d'un procédé permettant d'exécuter un test d'un tel circuit.

### Technique antérieure

Les circuits intégrés sont utilisés dans la conception de dispositifs électroniques ayant des applications diverses.

Que ce soit en production ou lors de la vie du produit, les circuits intégrés sont testés pour des défauts de fabrication. Ces tests requérant un accès font généralement appel à un protocole normalisé, connu sous la dénomination JTAG (Joint Test Action Group), par l'intermédiaire d'un port dédié du circuit intégré.

L'interface JTAG est couramment utilisée pour tester des mémoires, notamment des mémoires non-volatiles, et est susceptible d'être utilisée en production ainsi que dans la vie du produit, notamment lors d'opérations de maintenance afin d'identifier de potentiels défauts provenant de la fabrication. Le circuit intégré est alors généralement renvoyé au fabriquant. En particulier, des utilisateurs peuvent vouloir retourner le produit au fabriquant afin qu'il soit re-testé pour défauts de fabrication. L'utilisateur n'exécute pas ces tests comme étant une opération de routine de maintenance. L'utilisateur constate un problème, soupçonne qu'il pourrait s'agir d'un défaut de fabrication et renvoie le produit afin que le fabriquant puisse réexécuter un test de balayage (scan) pour analyser le défaut.

Les procédures de test et l'accès aux informations contenues dans les mémoires d'un circuit intégré sont susceptibles de poser problème dans des applications où ces mémoires contiennent des informations censées être cachées du fabricant. Il peut s'agir de clés d'authentification ou de chiffrement (plus généralement de mots de passe, codes ou clés utilisés dans la vie du circuit), de codes logiciels ou protocoles propriétaires stockés dans le circuit lors d'une phase de personnalisation effectuée par l'utilisateur final du circuit ou par une entité intermédiaire entre le fabricant et cet utilisateur. Ces éléments constituent des informations à cacher du fabriquant (secrets), qu'il n'est généralement pas souhaitable de communiquer au fabricant du circuit intégré.

Dans le cas où les mémoires non volatiles du circuit sont de type effaçable ou reprogrammable (mémoire flash ou EPROM), il est possible d'effacer des zones de la mémoire contenant le "secret" avant de retourner le circuit pour analyse de défauts. Par contre, lorsque les mémoires non volatiles sont de type fusible, leur programmation est irréversible et il est alors problématique de laisser l'accès au circuit via son interface JTAG lors d'une exécution de tests de fonctionnement des composants du circuit.

Le document US 2012/278630 A1 décrit un interface JTAG sécurisé.

### Résumé de l'invention

Il existe un besoin d'améliorer la sécurité et l'efficacité des procédés de test des dispositifs à circuits intégrés contenant des mémoires non volatiles à programmation irréversible.

Un mode de réalisation pallie tout ou partie des inconvénients des dispositifs à circuits intégrés connus.

Un mode de réalisation prévoit un procédé dans lequel un état d'un circuit intégré entre un premier état, autorisant un accès pour lecture d'une première zone d'une mémoire non volatile de type fusible à une unité de traitement, et un deuxième état, interdisant l'accès pour lecture de ladite mémoire à l'unité de traitement, est conditionné par une vérification, par une machine à états finis, d'un premier mot de type fusible de ladite mémoire, représentant un nombre de transitions vers ledit premier état, et d'un deuxième mot de type fusible de ladite mémoire, représentant un nombre de transitions vers ledit deuxième état.

Un mode de réalisation prévoit un circuit intégré comportant une machine à états finis configuré pour conditionner un état du circuit intégré entre un premier état, autorisant l'accès pour lecture d'une première zone d'une mémoire non volatile de type fusible à une unité de traitement, et un deuxième état, interdisant l'accès pour lecture de ladite mémoire à l'unité de traitement, à une vérification des valeurs d'un premier mot de type fusible de ladite mémoire, représentant un nombre de transitions vers ledit premier état, et d'un deuxième mot de type fusible de ladite mémoire, représentant un nombre de transitions vers ledit deuxième état.

Selon un mode de réalisation, ladite vérification consiste à comparer les valeurs respectives desdits premier et deuxième mots et à vérifier la valeur du bit le plus significatif du premier mot.

Selon un mode de réalisation, le circuit est dans le premier état si la valeur du deuxième mot est plus basse que la valeur du premier mot ou si le bit le plus significatif du premier mot est grillé.

Selon un mode de réalisation, ladite vérification est effectuée à chaque réinitialisation du circuit intégré.

Selon un mode de réalisation, dans le premier état, un test de balayage du circuit intégré est interdit.

Selon un mode de réalisation, dans le deuxième état, un test de balayage du circuit intégré est permis, excepté pour la mémoire non volatile de type fusible.

Selon un mode de réalisation :
- chaque transition dudit circuit intégré dans le premier état est précédée par une incrémentation d'un premier compteur défini par un premier mot de ladite mémoire ; et
- chaque transition dudit circuit intégré dans le deuxième état est précédée par une incrémentation d'un deuxième compteur défini par un deuxième mot de ladite mémoire.

Selon un mode de réalisation, une incrémentation du deuxième compteur est provoquée exclusivement par la machine d'état.

Selon un mode de réalisation, une incrémentation du premier compteur est accessible à l'unité de traitement.

Selon un mode de réalisation, une transition dudit circuit du premier état vers le deuxième état est effectuée si, et seulement si, en sortant de réinitialisation, une valeur, entrée dans un registre à partir de l'extérieur du circuit pendant que ledit circuit est en cours de réinitialisation, correspond à un code stocké dans ladite première zone de la mémoire non volatile de type fusible, ledit code étant uniquement lisible par la machine à états finis.

Selon un mode de réalisation, toute introduction de valeur dans ledit registre, lorsque le circuit intégré est dans le premier état en sortant de réinitialisation, incrémente un troisième compteur défini par un troisième mot de ladite mémoire à condition que le bit le plus significatif dudit troisième mot soit différent de 1.

Selon un mode de réalisation, après réinitialisation, le circuit est dans le deuxième état si :
la valeur du troisième compteur est supérieure à la valeur du deuxième compteur ; ou
le bit de type fusible le plus significatif du premier mot de type fusible est dans un état programmé ; ou
le bit de type fusible le plus significatif du troisième mot de type fusible est dans un état programmé.

Selon un mode de réalisation, le circuit est dans le premier état si :
la valeur du premier compteur est inférieure ou égale à la valeur du deuxième compteur ; et
les bits de type fusible les plus significatifs des troisième et premier mots de type fusible sont dans un état non programmé.

### Brève description des dessins

Ces caractéristiques et avantages, ainsi que d'autres, seront exposés en détail dans la description suivante de modes de réalisation et modes de mise en oeuvre particuliers faite à titre non limitatif en relation avec les figures jointes parmi lesquelles :

la figure 1 représente, de façon très schématique et sous forme de blocs, un mode de réalisation d'un dispositif à circuit intégré du type auquel s'appliquent, à titre d'exemple, des modes de réalisation décrits ;

la figure 2 représente, de façon schématique et sous forme de blocs, plus détaillée qu'en figure 1, un mode de réalisation de circuit intégré du type auquel s'appliquent, à titre d'exemple, des modes de réalisation décrits ;

la figure 3 est un arbre de décision illustrant un mode de mise en oeuvre d'un procédé de protection du contenu d'une mémoire fusible ; et

la figure 4 est un organigramme représentant des étapes d'un mode de mise en oeuvre d'une transition vers un mode de test de balayage d'un circuit intégré.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la conception de circuits intégrés est bien connue de la personne du métier et certains composants n'ont pas été décrits dans la suite.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

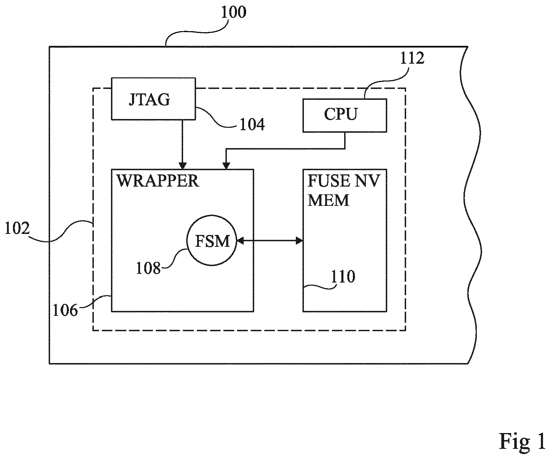

La figure 1 représente, de façon très schématique et sous forme de blocs, un mode de réalisation d'un dispositif électronique 100 comprenant un circuit intégré 102 du type auquel s'appliquent, à titre d'exemple, des modes de réalisation décrits.

Le dispositif électronique est, par exemple, une carte électronique telle qu'une carte à microcircuit, un matériel à usage informatique, un circuit à microprocesseur, etc.

Dans les applications visées par la présente description, le circuit intégré 102 comprend une mémoire non volatile non réinscriptible, de type fusible (FUSE NV MEM) 110. Par défaut, c'est-à-dire en sortie de fabrication, tous les bits de type fusible de la mémoire 110 sont dans un même état, arbitrairement 0. Cet état correspond, selon l'état natif des bits fusibles, par exemple, à un état non conducteur ou "bloqué", des éléments de mémorisation définissant les bits. Lors d'une personnalisation du dispositif électronique 100, précédant son acquisition par un utilisateur final, des données sont stockées sur la mémoire non volatile 110 en commutant les états de (en grillant) certains bits de la mémoire (de mots mémoire) vers l'état inverse 1, correspondant par exemple à un état conducteur ou "passant" des éléments de mémorisation correspondants.

La désignation "0" ou "1" des états respectifs non-conducteur et conducteur des bits mémoire est arbitraire et une autre convention, par exemple inverse : 0 pour conducteur et 1 pour non-conducteur, peut être prise en fonction de l'application.

Parmi les données stockées en mémoire 110, certaines ne présentent pas de sensibilité particulière en termes de confidentialité, mais d'autres sont considérées comme étant des données secrètes qui ne doivent pas sortir du circuit une fois qu'elles y ont été introduites. Le circuit intégré 102 comprend, en outre, une unité de traitement (CPU) 112, ayant accès à la mémoire 110 par l'intermédiaire d'un adaptateur 106 (WRAPPER). Le circuit intégré 102 comprend, en outre, un port d'accès 104 de type JTAG (de l'anglais Joint Test Action Group) permettant à un utilisateur de connecter une interface de type JTAG (non représentée) au circuit afin de demander l'exécution de tests du système. Ces tests sont, par exemple, des tests de continuité du circuit détectant d'éventuels courts-circuits ou encore des tests des fonctions logiques du circuit. Les tests ne peuvent être effectués lors de la conception de prototypes, lors de la fabrication, ou encore lorsque le dispositif 100 est retourné au fabriquant pour analyse de défaut(s).

Néanmoins, l'accès au "secret" (aux données confidentielles) ne doit pas être possible via l'interface de test. Pour cela, dans une étape de (en fin de) fabrication ou de personnalisation d'un circuit, avant que les informations secrètes du fabriquant soient introduites dans le circuit, le circuit est « fermé », ce qui correspond à un état dans lequel l'exécution des tests de balayage (scan) est impossible.

Cependant, interdire tout test du circuit une fois celui-ci en utilisation interdit également au fabricant toute possibilité d'analyse de défauts susceptibles de provenir de la fabrication.

Les modes de réalisation décrits prévoient un nouveau mécanisme pour autoriser l'accès au circuit intégré lors de tests, sans nuire à la sécurité de ces données.

Pour cela, on prévoit la possibilité d'"ouvrir" le circuit, c'est-à-dire d'autoriser le port d'accès JTAG 104 afin de lancer des tests de balayage tout en protégeant l'accès au "secret".

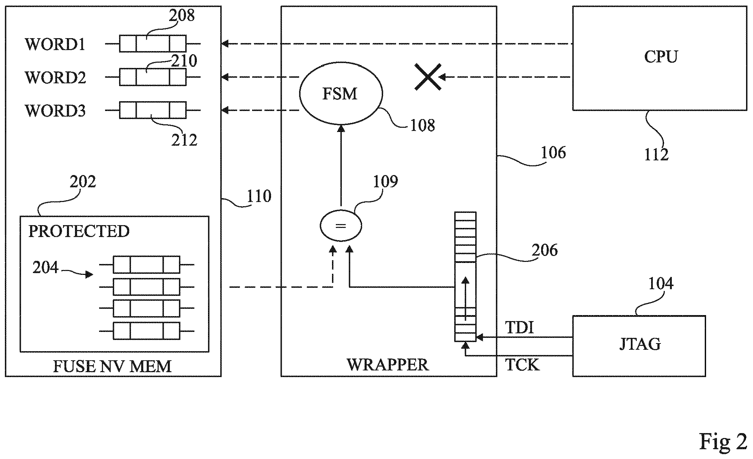

Ainsi, on prévoit que le circuit ait, notamment du point de vue du port JTAG 104, un état "fermé" dans lequel les tests de balayage sont bloqués mais dans lequel l'adaptateur 106 autorise l'unité de traitement 112 à avoir accès à la mémoire 110, y compris à sa partie protégée (202, Fig. 2) contenant le "secret", et un état "ouvert" dans lequel les tests de balayage sont permis, mais dans lequel l'adaptateur 106 interdit tout accès à la zone protégée 202 de la mémoire 110 à l'unité de traitement 112 et cela même par l'intermédiaire des tests de balayage.

Dans ce but, les modes de réalisation décrits prévoient la présence d'une machine à états finis (FSM) 108 pour commander la transition de l'état "fermé" du circuit vers l'état "ouvert". De plus, l'adaptateur 106, contenu dans le circuit 102, assure une compatibilité entre des données pouvant être saisies via l'interface JTAG et les données stockées dans la mémoire non volatile non réinscriptible 110. L'adaptateur 106 contient lui-même la machine à états finis 108 et est relié au port d'accès 104 et à la mémoire non volatile 110. Dans ce mode de réalisation, le port d'accès JTAG 104 n'est pas relié à l'unité de traitement 112 et, en particulier, les fonctionnements respectifs du processeur 112 et de la machine à états finis 108 sont indépendants l'un de l'autre.

La figure 2 représente, de façon schématique et sous forme de blocs, plus détaillée qu'en figure 1, un mode de réalisation de circuit intégré du type auquel s'appliquent, à titre d'exemple, des modes de réalisation décrits.

Selon les modes de réalisation décrits, on prévoit que la mémoire non volatile de type fusible 110 comporte ou se décompose en plusieurs zones mémoire distinctes.

Une première zone (PROTECTED) 202, contenant des données protégées, contient l'ensemble des données (programme ou données proprement dites) dont l'accès doit être réservé à un fonctionnement dans un mode ou environnement sécurisé, c'est-à-dire lorsque que le circuit est dans l'état fermé. Ces données sont stockées par l'utilisateur final du circuit ou par une entité intermédiaire entre le fabricant et cet utilisateur. Ces données peuvent être des clefs d'authentification ou de chiffrement, des codes logiciels ou protocoles propriétaires, etc. Parmi ces données, des codes ou mots de passe sont contenus dans des mots mémoire dédiés 204. Ce ou ces codes sont notamment utilisés pour conditionner la réouverture du circuit.

Le code 204 n'est lisible que par l'adaptateur 106 et, plus particulièrement, par la machine d'états 108. Le code 204 peut être stocké dans la zone 202 par le fabricant lors de la production du circuit 102, mais est préférentiellement choisi et stocké lors de la phase de personnalisation. Le code 204 correspond à un mot de passe secret de type fusible qui, une fois programmé (ou verrouillé), est uniquement accessible par la machine à états finis 108.

A chaque démarrage (boot) du circuit, la machine d'états 108 détermine si la puce est dans un état « ouvert » ou dans un état « fermé ». Si la puce est dans un état « fermé », et si un contenu a été entré dans un registre 206 de l'adaptateur 106 avant que la puce ne sorte de réinitialisation, la machine à états finis compare le code 204 avec ce contenu. Durant la période dans laquelle la puce est en réinitialisation, le port d'accès JTAG 104 est fonctionnel et du contenu peut être entré et est alors stocké dans le registre 206.

Le registre 206, accessible via le port JTAG 104, est typiquement un registre à décalage (stockage volatil) écrit via le port JTAG et lu par la machine d'états 108. L'écriture du registre est effectuée, de façon usuelle, par une entrée de données TDI en étant séquencée par un signal TCK provenant de l'interface JTAG. La fonction 109 de comparaison entre les données saisies via le port 104 et celles contenues dans le code 204 fait également partie de la machine à états finis.

Le fait de conditionner l'ouverture du circuit à la saisie, via l'interface JTAG, de données correspondant à un code 204 stocké lors de la personnalisation et de la fermeture du circuit participe à préserver les données que l'utilisateur ne souhaite pas rendre accessibles au fabricant. Le code 204 peut uniquement être lu et manipulé par la machine à états finis 108, et jamais par l'unité de traitement 112.

En pratique, les besoins de test via l'interface JTAG au cours de la vie du produit (après personnalisation) ne sont pas nombreux. Le plus souvent, cela ne se produit qu'une ou deux fois (tout au plus une dizaine de fois) dans la vie du produit. On prévoit de tirer profit de ce besoin limité pour restreindre le nombre possible de tentatives d'ouverture du circuit. Limiter le nombre possible de tentatives d'ouverture évite le risque d'un piratage par de multiples essais de mots de passe via l'interface JTAG.

Pour ce faire, on prévoit dans la mémoire 110 une deuxième zone contenant des premier, deuxième et troisième mots mémoire 208 (WORD1), 210 (WORD2) et 212 (WORD3) ayant des fonctions spécifiques liées à l'ouverture et à la fermeture du circuit. Plus particulièrement, chaque mot 208, 210, 212 constitue un compteur, respectivement, du nombre de fermetures, du nombre d'ouvertures et du nombre de saisies de données via le port 104 lorsque la puce est en réinitialisation. Initialement, tous les bits de type fusible des mots 208, 210 et 212 sont dans un même état, arbitrairement 0. Le mot 210 peut uniquement être grillé par la machine d'état 108 (et non par l'unité 112).

La longueur des mots 208, 210 et 212 peut être la même ou différer d'un mot à l'autre. Cette longueur conditionne, selon le mot, le nombre de fermetures, d'ouvertures et de tentatives de saisie de mot de passe via l'interface JTAG. De préférence, chaque mot 208, 210, 212 comporte au moins 8 bits, de préférence 32 bits. Comme les bits des mots 208 à 212 sont des bits programmables de façon irréversible, le compteur correspondant ne dénombre pas un nombre pouvant atteindre 2 élevé à la puissance du nombre de bits, mais un nombre pouvant atteindre au maximum le nombre de bits.

Pour simplifier, on fera par la suite référence au grillage d'un bit d'un mot fusible 208, 210, 212 par opération. On notera cependant qu'en pratique, pour des questions de fiabilité, on préférera griller les bits par groupe de plusieurs bits d'un même mot, par exemple quatre bits, à chaque programmation. Cela permet de rendre fiable la prise en compte du nombre donné par le compteur correspondant. En lecture, on considère alors qu'il suffit qu'un seul des bits d'un groupe soit à l'état 1 pour que le changement de valeur soit pris en compte. Ainsi, en prenant l'exemple de mots de 32 bits, le compteur correspondant peut prendre 8 valeurs.

A chaque fois que, lors d'un démarrage du circuit fermé, des données ont été stockées dans le registre 206 avant que la puce ne sorte de réinitialisation, la machine d'états 108 grille un bit (ou groupe de bits) du compteur représenté par le mot 212. Cela utilise l'une des opportunités de deviner le mot de passe. Une fois que la totalité des bits du mot 212 sont dans l'état 1, le circuit 102 est verrouillé dans l'état "fermé". Par exemple, dans le cas où le mot 212 est composé de 8 bits (ou 32 bits programmés par groupes de 4 bits), le circuit est verrouillé après huit tentatives d'introduction d'un mot de passe par l'interface JTAG.

Dans le cas où les données saisies dans l'interface correspondent (par exemple sont les mêmes ou sont liées par une combinaison logique opérée par la fonction 109) au code 204, cela signifie que l'entité en possession du circuit a le bon mot de passe pour "ouvrir" le circuit. Si la puce n'est pas bloquée dans l'état « fermé », la machine à états finis 108 grille un bit du mot 210 et ainsi « réouvre » la puce. Cela utilise une des opportunités d'ouverture du circuit.

Le circuit, excepté la mémoire non volatile de type fusible 110, peut alors faire l'objet d'un test de balayage. Une puce « ouverte » peut être « fermée » n'importe quand en grillant un bit (ou un groupe de bits) du compteur représenté par le mot 208. Cette opération peut être exécutée par l'unité de traitement 112 ou par un débogueur relié au port JTAG 104.

La fermeture du circuit implique de griller un bit du mot 208, utilisant ainsi une oportunité de fermeture du circuit. Si tous les bits du mot 208 sont grillés, le circuit est bloqué dans l'état fermé et ne peut plus être ouvert à nouveau.

Dans un mode de réalisation simplifié, seuls les compteurs 208 et 210 sont prévus. En effet, le compteur 212 empêche seulement une attaque brutale par supposition de mot de passe. Cela est utile si le mot de passe 204 est court.

Bien que cela ne soit pas directement lié à la protection du contenu de la mémoire 110 lors de l'exécution des tests, un avantage induit par la mise en oeuvre des réouvertures par la machine d'état 108 plutôt que par l'unité de traitement 112 est que le fait de rouvrir pour effectuer des tests de balayage fonctionnera même lorsque le défaut de fabrication se situe dans l'unité de traitement 112 elle-même. Or, l'unité de traitement 112 occupe une surface importante du circuit 102, notamment comparé à l'encombrement de la machine d'états 108, et la probabilité que le défaut ayant provoqué le dysfonctionnement du circuit y soit présent n'est pas négligeable.

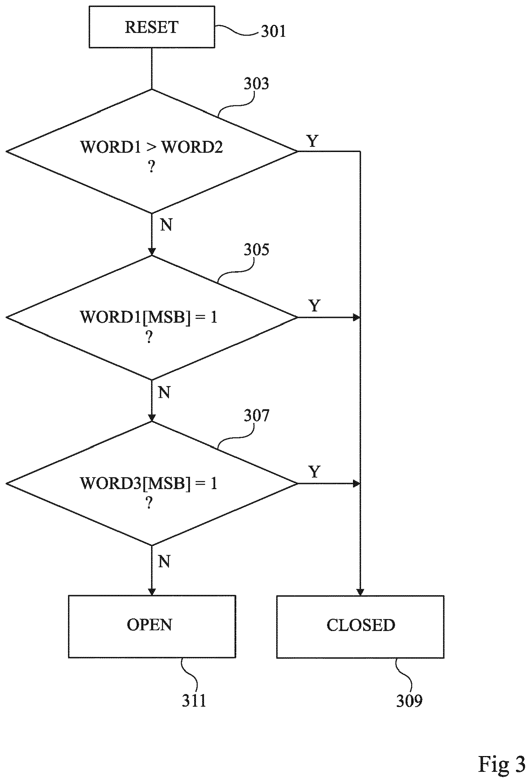

La figure 3 est un arbre de décision illustrant un mode de mise en oeuvre d'un procédé de protection du contenu d'une mémoire fusible.

Plus particulièrement, la figure 3 est un arbre de décision représentant les conditions auxquelles le circuit 102 est dans l'état ouvert, respectivement dans l'état fermé.

A chaque fin de démarrage ou fin de réinitialisation (bloc 301, RESET) du circuit 102, la machine à états finis 108 vérifie l'état (ouvert ou fermé) dans lequel se trouve le circuit 102. L'état est déterminé par les valeurs respectives des premier, deuxième et troisième mots 208, 210 et 212.

De préférence, les vérifications des compteurs respectifs représentés par les mots 208, 210 et 212 s'effectuent en déterminant le rang du bit le plus significatif qui se trouve à l'état 1. Dans l'exemple de la figure 3, on suppose que les compteurs sont tous sur un même nombre de bits.

Ainsi, dans l'exemple représenté, la machine à états finis 108 commence par vérifier (bloc 303, WORD 1 > WORD 2 ?) si la valeur du premier mot 208 est supérieure à la valeur du deuxième mot 210. Si c'est le cas (sortie Y du bloc 303), cela signifie que la dernière opération sur les mots 208, 210 et 212 a consisté en une fermeture du circuit 102 et l'état du circuit 102 reste donc à l'état fermé (bloc 309, CLOSED). Si ce n'est pas le cas (sortie N du bloc 303), autrement dit si la valeur du premier mot 208 est inférieure ou égale à la valeur du deuxième mot 210, la machine à états finis 108 vérifie (bloc 305, WORD1[MSB]=1 ?) si le bit le plus significatif (MSB) du premier mot 210 est dans l'état 1. Si c'est le cas (sortie Y du bloc 305), cela signifie que le nombre maximum de fermetures du circuit a été atteint et l'état du circuit 102 est alors à l'état fermé (bloc 309, CLOSED). Sinon (sortie N du bloc 305), la machine à états finis 108 vérifie optionnellement (bloc 307, WORD3[MSB]=1 ?) si le bit le plus significatif (MSB) du troisième mot 212 est dans l'état 1. Si c'est le cas (sortie Y du bloc 307), cela signifie que le nombre maximum de tentatives d'introduction de mots de passe a été atteint et le circuit reste alors à l'état fermé 309. Sinon (sortie N du bloc 307 ou du bloc 305, si l'étape 307 est omise), l'état du circuit 102 est l'état ouvert (bloc 311, OPEN) et l'interface de test peut envoyer, via le registre à décalage, les instructions requises pour exécuter le test de balayage du circuit.

En d'autres termes, pour que l'état du circuit 102 soit l'état ouvert 311, les bits les plus significatifs des premier et troisième mots 208 et 212 doivent avoir pour valeur 0 et la valeur du deuxième mot 210 doit être inférieure ou égale à la valeur du premier mot 208.

L'ordre des étapes 303, 305 et 307 de la figure 3 n'a pas d'importance. En pratique, ces étapes peuvent être effectuées en parallèle ou indépendamment les unes des autres par la machine d'état 108 dans la mesure où il suffit qu'une seule des étapes donne un résultat vrai pour que le circuit soit dans l'état fermé.

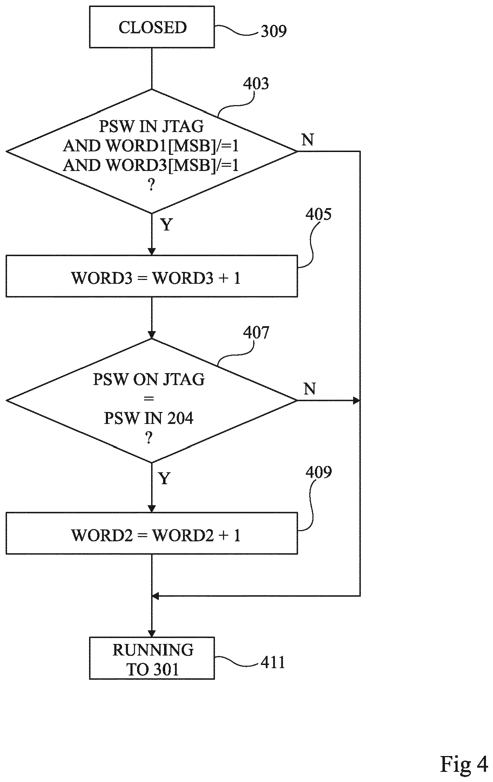

La figure 4 est un organigramme représentant des étapes d'un mode de mise en oeuvre d'une transition en mode test d'un circuit intégré.

Plus précisément, la figure 4 est un organigramme représentant des opérations d'un mode de mise en oeuvre de la transition de l'état fermé 309 (CLOSED) vers une réinitialisation 301 (figure 3).

Pendant que le circuit 102 est en cours de réinitialisation, si la machine à états finis 108 indique, à la fin des vérifications illustrées par la figure 3, que le circuit 102 est dans un état fermé (bloc 309, CLOSED), la machine d'état 108 opère une vérification bloc 403 (PSW IN JTAG AND WORD1[MSB]/=1 AND WORD3[MSB]/=1 ?), du contenu du registre 206, afin de détecter si un mot de passe a été saisi via l'interface JTAG pendant la réinitialisation, et des valeurs des premier et troisième mots pour vérifier qu'aucun d'entre eux n'a son bit le plus significatif dans l'état 1 (i.e. grillé).

Si aucun mot de passe n'a été saisi (sortie N du bloc 403), le processus de vérification de la demande de test se termine (bloc 411, RUNNING TO 301) et le circuit restera, une fois réinitialisé en bloc 301, dans l'état fermé.

Si un mot de passe à été saisi (sortie Y du bloc 403), la machine à états finis 108 grille, selon le mode de réalisation dans lequel le troisième mot 212 existe, l'état du bit de plus bas ordre étant dans l'état 0 du mot 212 vers l'état 1. Cette action incrémente (bloc 405, WORD3 = WORD3 + 1) le compteur du nombre de tentatives.

Après l'étape 403, et quand elle existe l'étape 405, le code 204 est lu par l'adaptateur 106. Dans une étape 407, l'adaptateur 106 vérifie (bloc 407, PSW ON JTAG = PSW IN 204) la correspondance (par exemple, l'égalité) entre les données présentes dans le registre 206 et le code 204.

Dans le cas où les données du registre 206 et le code 204 ne correspondent pas (sortie N du bloc 407), le processus de vérification s'arrête (bloc 411) et le circuit va, de préférence par la mise en oeuvre des étapes de la figure 3, rester fermé.

Dans le cas où les données du registre 206 et le code 204 correspondent (sortie Y du bloc 407), la machine à états finis 108 grille (bloc 409, WORD2 = WORD2 + 1) l'état du bit du deuxième mot 210 de plus bas ordre étant dans l'état 0 vers l'état 1 de façon à ouvrir le circuit. Puis, le processus de vérification se termine (bloc 411) et le circuit se trouvera dans l'état ouvert après la prochaine réinitialisation 301.

Initialement (en sortie de fabrication), tous les bits de la mémoire fusible 110 (au moins ceux de la zone 202 et des mots 208, 210, et 212) sont de préférence à l'état 0. Par conséquent, le circuit est dans l'état ouvert, ce qui n'est pas gênant dans la mesure où aucun "secret" n'a été introduit dans la zone 202.

La transition du mode ouvert vers l'état fermé ne posant pas de problème quant à la sécurité des données stockées dans la zone 202, cette transition peut être déclenchée y compris par l'unité de traitement 112.

Une transition initiale est préférentiellement déclenchée avant de personnaliser les données censées rester protégées et de stocker le code 204 dans la zone 202. Par exemple, un code programme exécuté par l'unité de traitement provoque la fusion du bit le moins significatif (LSB) du mot 208 (WORD1), ce qui placera le circuit dans l'état fermé au prochain redémarrage.

Selon un autre mode de réalisation, un débogueur relié au circuit 102 peut griller le bit du mot 208 de plus bas ordre étant encore à l'état 0 pour fermer la puce.

Selon un autre mode de réalisation, la première transition vers l'état fermé peut griller tous les bits du mot 208 d'un seul coup. À titre d'exemple, WORD1=7. Afin de rouvrir la puce, il sera alors nécessaire de saisir le mot de passe plusieurs fois, par exemple 7 fois, et la transition vers l'état ouvert sera réussie lors de la dernière (par exemple la 7^{ème}) saisie (quand la valeur du mot 210 atteindra 7). Ce faisant, une transition de l'état fermé vert l'état ouvert ne peut se produire qu'une seule fois.

Selon un autre mode de réalisation, la vérification effectuée sur le bit le plus significatif du mot 208 (nombre maximum de fermetures atteint) peut être remplacée par une vérification effectuée sur le bit le plus significatif du mot 210 (nombre maximum d'ouvertures atteint).

Un avantage des modes de réalisation et modes de mise en oeuvre décrits est qu'uniquement la machine à états finis 108 peut lire le code 204. L'unité centrale de traitement 112 ne peut pas lire le code 204. Ainsi, la surface du circuit sur laquelle une attaque peut être effectuée afin d'extraire le code 204 est réduite. En d'autres termes, la réouverture du circuit peut uniquement être effectuée par la machine à états finis 108, et n'implique pas l'unité centrale de traitement. Ainsi la surface du circuit sur laquelle une attaque frauduleuse peut être effectuée dans le but de réouvrir le circuit est réduite.

Un autre avantage des modes de réalisation et modes de mise en oeuvre décrits est que les réouvertures sont exécutées par une machine à états finis indépendante de l'unité de traitement, permettant ainsi la détection d'un ou plusieurs défauts qui pourraient être présents sur l'unité de traitement.

Un autre avantage des modes de réalisation décrits est que l'implémentation de la machine à états finis nécessite une logique combinatoire simple pouvant être mise en oeuvre de manière robuste.

Divers modes de réalisation, modes de mise en oeuvre et variantes ont été décrits. La personne du métier comprendra que certaines caractéristiques de ces divers modes de réalisation, modes de mise en oeuvre et variantes pourraient être combinées, et d'autres variantes apparaîtront à la personne du métier.

Enfin, la mise en oeuvre pratique des modes de réalisation, modes de mise en oeuvre et variantes décrits est à la portée de la personne du métier à partir des indications fonctionnelles données ci-dessus. En particulier, les tailles du code 204 ainsi que des mots 208, 210 et 212 peuvent varier d'un mode de réalisation à un autre.

## Revendications

1. Procédé dans lequel un état d'un circuit intégré (102) entre un premier état (CLOSED), autorisant un accès pour lecture d'une première zone (202) d'une mémoire non volatile de type fusible (110) à une unité de traitement (112), et un deuxième état (OPEN), interdisant l'accès pour lecture de ladite mémoire à l'unité de traitement (112), est conditionné par une vérification, par une machine à états finis (108), d'un premier mot de type fusible (WORD1) de ladite mémoire, représentant un nombre de transitions vers ledit premier état, et d'un deuxième mot de type fusible (WORD2) de ladite mémoire, représentant un nombre de transitions vers ledit deuxième état.

2. Circuit intégré comportant une machine à états finis (108) configurée pour conditionner un état du circuit intégré entre un premier état (CLOSED), autorisant l'accès pour lecture d'une mémoire non volatile de type fusible (110) à une unité de traitement (112), et un deuxième état (OPEN), interdisant l'accès pour lecture de ladite mémoire à l'unité de traitement (112), à une vérification des valeurs d'un premier mot de type fusible (WORD1) de ladite mémoire, représentant un nombre de transitions vers ledit premier état, et d'un deuxième mot de type fusible (WORD2) de ladite mémoire, représentant un nombre de transitions vers ledit deuxième état.

3. Procédé selon la revendication 1, ou circuit selon la revendication 2, dans lequel ladite vérification consiste à comparer (303) les valeurs respectives desdits premier et deuxième mots et à vérifier (305) la valeur du bit le plus significatif du premier mot.

4. Procédé ou circuit selon la revendication 3, dans lequel le circuit est dans le premier état (CLOSED) si la valeur du deuxième mot (WORD2) est plus basse que la valeur du premier mot (WORD1) ou si le bit le plus significatif du premier mot est grillé.

5. Procédé selon la revendication 1, 3 ou 4, ou circuit selon l'une quelconque des revendications 2 à 4, dans lequel ladite vérification est effectuée à chaque réinitialisation du circuit intégré.

6. Procédé selon l'une quelconque des revendications 1, 3 à 5, ou circuit selon l'une quelconque des revendications 2 à 5, dans lequel, dans le premier état (CLOSED), un test de balayage du circuit intégré est interdit.

7. Procédé selon l'une quelconques des revendications 1, 3 à 6, ou circuit selon l'une quelconque des revendications 2 à 6, dans lequel, dans le deuxième état (OPEN), un test de balayage du circuit intégré est permis, excepté pour la mémoire non volatile de type fusible (110).

8. Procédé selon l'une quelconque des revendications 1, 3 à 7, ou circuit selon l'une quelconque des revendications 2 à 7 dans lequel :
- chaque transition dudit circuit intégré dans le premier état (CLOSED) est précédée par une incrémentation d'un premier compteur (208) défini par un premier mot (WORD1) de ladite mémoire (110) ; et
- chaque transition dudit circuit intégré dans le deuxième état (OPEN) est précédée par une incrémentation d'un deuxième compteur (210) défini par un deuxième mot (WORD2) de ladite mémoire (110).

9. Procédé ou circuit selon la revendication 8, dans lequel une incrémentation du deuxième compteur (210) est provoquée exclusivement par la machine d'état.

10. Procédé ou circuit selon la revendication 8 ou 9, dans lequel une incrémentation du premier compteur (208) est accessible à l'unité de traitement (112).

11. Procédé selon l'une quelconque des revendications 1, 3 à 10, ou circuit selon l'une quelconque des revendications 2 à 10, dans lequel une transition dudit circuit du premier état (CLOSED) vers le deuxième état (OPEN) est effectuée si, et seulement si, en sortant de réinitialisation, une valeur, entrée dans un registre à partir de l'extérieur du circuit pendant que ledit circuit est en cours de réinitialisation, correspond à un code (204) stocké dans ladite première zone (202) de la mémoire non volatile de type fusible (110), ledit code étant uniquement lisible par la machine à états finis.

12. Procédé ou circuit selon la revendication 11, dans lequel toute introduction de valeur dans ledit registre, lorsque le circuit intégré est dans le premier état (CLOSED) en sortant de réinitialisation, incrémente un troisième compteur (212) défini par un troisième mot (WORD3) de ladite mémoire (110) à condition que le bit le plus significatif dudit troisième mot soit différent de 1.

13. Procédé ou circuit selon la revendication 12, dans lequel, après réinitialisation, le circuit est dans le deuxième état (OPEN) si :
la valeur du troisième compteur (208) est supérieure à la valeur du deuxième compteur (210) ; ou
le bit de type fusible le plus significatif du premier mot de type fusible (WORD1) est dans un état programmé ; ou
le bit de type fusible le plus significatif du troisième mot de type fusible (WORD3) est dans un état programmé.

14. Procédé ou circuit selon la revendication 12 ou 13, dans lequel le circuit est dans le premier état (CLOSED) si :
la valeur du premier compteur (208) est inférieure ou égale à la valeur du deuxième compteur (210) ; et
les bits de type fusible les plus significatifs des troisième (WORD3) et premier (WORD1) mots de type fusible sont dans un état non programmé.

## Patentansprüche

1. Verfahren, bei dem ein Zustand einer integrierten Schaltung zwischen einem ersten Zustand (CLOSED), der einen Lesezugriff auf einen ersten Bereich (202) eines nichtflüchtigen Speichers (110) vom Sicherungstyp durch eine Verarbeitungseinheit (112) erlaubt, und einem zweiten Zustand (OPEN), der den Lesezugriff auf den Speicher für die Verarbeitungseinheit (112) verbietet, bedingt ist durch eine Verifizierung einer endlichen Zustandsmaschine (108) von Werten eines ersten Sicherungsworts (WORD1) des Speichers, das für eine Anzahl von Übergängen in den ersten Zustand repräsentativ ist, und eines zweiten Sicherungsworts (WORD2) des Speichers, das für eine Anzahl von Übergängen in den zweiten Zustand repräsentativ ist.

2. Integrierte Schaltung aufweisend eine endlichen Zustandsmaschine (108), die konfiguriert ist zum Bedingen eines Zustands der integrierenden Schaltung zwischen einem ersten Zustand (CLOSED), der einen Lesezugriff auf einen ersten Bereich (202) eines nichtflüchtigen Speichers (110) vom Sicherungstyp durch eine Verarbeitungseinheit (112) erlaubt, und einem zweiten Zustand (OPEN), der den Lesezugriff auf den Speicher für die Verarbeitungseinheit (112) verbietet, durch eine Verifizierung von Werten eines ersten Sicherungsworts (WORD1) des Speichers, das für eine Anzahl von Übergängen in den ersten Zustand repräsentativ ist, und eines zweiten Sicherungsworts (WORD2) des Speichers, das für eine Anzahl von Übergängen in den zweiten Zustand repräsentativ ist.

3. Verfahren nach Anspruch 1 oder Schaltung nach Anspruch 2, **dadurch gekennzeichnet, dass** die Verifizierung darin besteht, die jeweiligen Werte des ersten und zweiten Wortes zu vergleichen (303) und den Wert des höchstwertigen Bits des ersten Wortes zu überprüfen (305).

4. Verfahren oder Schaltung nach Anspruch 3, wobei sich die Schaltung im ersten Zustand (CLOSED) befindet, wenn der Wert des zweiten Wortes (WORD2) niedriger ist als der Wert des ersten Wortes (WORD1) oder wenn das höchstwertige Bit des ersten Wortes verbrannt ist.

5. Verfahren nach einem der Ansprüche 1, 3 oder 4 oder Schaltung nach einem der Ansprüche 2 bis 4, wobei die Verifizierung bei jedem Reset der integrierten Schaltung durchgeführt wird.

6. Verfahren nach einem der Ansprüche 1, 3 bis 5 oder Schaltung nach einem der Ansprüche 2 bis 5, wobei im ersten Zustand (CLOSED) ein Scantest der integrierten Schaltung verboten ist.

7. Verfahren nach einem der Ansprüche 1, 3 bis 6 oder Schaltung nach einem der Ansprüche 2 bis 6, wobei im zweiten Zustand (OPEN) ein Scantest für die integrierte Schaltung mit Ausnahme des nichtflüchtigen Speichers (110) vom Sicherungstyp freigegeben ist.

8. Verfahren nach einem der Ansprüche 1, 3 bis 7, oder Schaltung nach einem der Ansprüche 2 bis 7, wobei:
- jedem Übergang der integrierten Schaltung in den ersten Zustand (CLOSED) eine Inkrementierung eines ersten Zählers (208) vorausgeht, der durch das erste Wort (WORD1) des Speichers (110) definiert ist
- jedem Übergang der integrierten Schaltung in den zweiten Zustand (OPEN) eine Inkrementierung eines zweiten Zählers (210) vorausgeht, der durch das zweite Wort (WORD2) des Speichers (110) definiert ist.

9. Verfahren oder Schaltung nach Anspruch 8, wobei eine Inkrementierung des zweiten Zählers (210) ausschließlich durch die endliche Zustandsmaschine verursacht wird.

10. Verfahren oder Schaltung nach Anspruch 8 oder 9, wobei eine Inkrementierung des ersten Zählers (208) für die Verarbeitungseinheit (112) zugänglich ist.

11. Verfahren nach einem der Ansprüche 1, 3 bis 10 oder Schaltung nach einem der Ansprüche 2 bis 10, wobei ein Übergang der Schaltung vom ersten Zustand (CLOSED) in den zweiten Zustand (OPEN) dann und nur dann erfolgt, wenn ein Wert, der von außerhalb der Schaltung in ein Register eingegeben wird, während sich die Schaltung im Reset befindet, einem Code (204) entspricht, der in dem ersten Bereich (202) des nichtflüchtigen Speichers (110) vom Sicherungstyp gespeichert ist, wobei der Code nur von der endlichen Zustandsmaschine lesbar ist.

12. Verfahren oder Schaltung nach Anspruch 11, wobei jede Eingabe eines Wertes in das Register, während sich die integrierte Schaltung im ersten Zustand (CLOSED) befindet, während sie aus der Reset kommt, einen dritten Zähler (212) inkrementiert, der durch ein drittes Wort (WORD3) des Speichers (110) definiert ist, vorausgesetzt, dass das höchstwertige Bit dieses dritten Wortes von 1 verschieden ist.

13. Verfahren oder Schaltung nach Anspruch 12, wobei sich die Schaltung nach dem Austritt aus dem Reset im zweiten Zustand (OPEN) befindet, wenn:
der Wert des dritten Zählers (208) größer ist als der Wert des zweiten Zählers (210); oder
das höchstwertige Sicherheitsbit des ersten Sicherungsworts (WORD1) sich in einem programmierten Zustand befindet, oder
das höchstwertige Sicherheitsbit des dritten Sicherungsworts (WORD3) in einem programmierten Zustand ist.

14. Verfahren oder Schaltung nach Anspruch 12 oder 13, wobei sich die Schaltung in dem ersten Zustand (CLOSED) befindet, wenn:
der Wert des ersten Zählers (208) kleiner als oder gleich dem Wert des zweiten Zählers (210) ist, und
die höchstwertigen Bits des dritten (WORD3) und des ersten (WORD1) Sicherungsworts sich in einem nicht programmierten Zustand befinden.

## Claims

1. Method wherein a state of an integrated circuit between a first state (CLOSED), allowing a reading access to a first area (202) of fuse-type non-volatile memory (110) by a processing unit (112), and a second state (OPEN), forbidding the reading access to said memory to the processing unit (112), is conditioned to a verification, by a finite state machine (108), of values of a first fuse word (WORD1) of said memory, representative of a number of transitions to said first state and of a second fuse word (WORD2) of said memory, representative of a number of transitions to said second state.

2. Integrated circuit comprising a finite state machine (108) configured to condition a state of the integrating circuit between a first state (CLOSED), allowing a reading access to a first area (202) of a fuse-type non-volatile memory (110) by a processing unit (112), and a second state (OPEN), forbidding the reading access to the said memory to the processing unit (112), to a verification of values of a first fuse word (WORD1) of said memory, representative of a number of transitions to said first state and of a second fuse word (WORD2) of said memory, representative of a number of transitions to said second state.

3. Method according to claim 1, or circuit according to claim 2, wherein said verification consists in comparing (303) the respective values of said first and second words and in checking (305) the value of the maximum significant bit of the first word.

4. Method or circuit according to claim 3, wherein the circuit is in the first state (CLOSED) if the value of the second word (WORD2) is lower than the value of the first word (WORD1) or if the maximum significant bit of the first word is blown.

5. Method according to anyone of claims 1, 3 or 4, or circuit according to anyone of claims 2 to 4, wherein said verification is performed at each reset of the integrated circuit.

6. Method according to anyone of claims 1, 3 to 5, or circuit according to anyone of claims 2 to 5, wherein, in the first state (CLOSED), a scan test of the integrated circuit is forbidden.

7. Method according to anyone of claims 1, 3 to 6, or circuit according to anyone of claims 2 to 6, wherein, in the second state (OPEN), a scan test is enabled for the integrated circuit except for the fuse-type non-volatile memory (110).

8. Method according to anyone of claims 1, 3 to 7, or circuit according to anyone of claims 2 to 7, wherein:
- each transition of said integrated circuit to the first state (CLOSED) is preceded by an incrementation of a first counter (208) defined by the first word (WORD1) of said memory (110);
- each transition of said integrated circuit to the second state (OPEN) is preceded by an incrementation of a second counter (210) defined by the second word (WORD2) of said memory (110).

9. Method or circuit according to claim 8, wherein an incrementation of the second counter (210) is exclusively caused by the state machine.

10. Method or circuit according to claim 8 or 9, wherein an incrementation of the first counter (208) is accessible to the processing unit (112).

11. Method according to anyone of claims 1, 3 to 10, or circuit according to anyone of claims 2 to 10, wherein a transition of said circuit from the first state (CLOSED) to the second state (OPEN) is performed if and only if, emerging from reset, a value, entered into a register from the outside of the circuit while said circuit is in reset, corresponds to a code (204) stored in said first area (202) of the fuse-type non-volatile memory (110), said code being only readable by the finite state machine.

12. Method or circuit according to claims 11, wherein any introduction of value in said register, while the integrated circuit is in the first state (CLOSED) while emerging from reset, increments a third counter (212) defined by a third word (WORD3) of said memory (110) provided that the maximum significant bit of this third word is different than 1.

13. Method or circuit according to claim 12, wherein, after emerging from the reset, the circuit is in the second state (OPEN) if:
the value of the third counter (208) is greater than the value of the second counter (210); or
the most significant fuse-bit of the first fuse-word (WORD1) is in a programmed state; or
the most significant fuse-bit of the third fuse-word (WORD3) is in a programmed state.

14. Method or circuit according to claim 12 or 13, wherein the circuit is in the first state (CLOSED) if:
the value of the first counter (208) is smaller than or equal to the value of the second counter (210); and
the most significant bits of the third (WORD3) and first (WORD1) fuse words are in a non-programmed state.
